(19)

Europäisches
Patentamt
European
Patent Office
Office européen
des brevets

(11)  **EP 4 459 831 A1**

(12)  **EUROPEAN PATENT APPLICATION**

(43) Date of publication:
**06.11.2024 Bulletin 2024/45**

(21) Application number: **24169562.6**

(22) Date of filing: **10.04.2024**

(51) International Patent Classification (IPC):
**H02J 7/00** $^{(2006.01)}$

(52) Cooperative Patent Classification (CPC):
**H02J 7/0019; H02J 7/0047; H02J 7/007188**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.04.2023 GR 20230100322**

(71) Applicants:
• **Aristotle University of Thessaloniki - Elke
54636 Thessaloniki (GR)**

• **Mademlis, Christos
55134 Kalamaria - Thessaloniki (GR)**
• **Jabour, Nikolaos
57000 Nea Redestos - Thessaloniki (GR)**
• **Tsioumas, Evangelos
54639 Thessaloniki (GR)**

(72) Inventor: **The designation of the inventor has not yet been filed**

(74) Representative: **Perivolaris, Georgios
Fragon 13
54626 Thessaloniki (GR)**

(54)  **METHOD FOR EQUALIZATION CURRENT REGULATION AND ENERGY SUPPORT OF BATTERY CELLS**

(57)     The invention relates to a method for regulating equalization and energy support currents of battery cells, based on a master-slave control structure, integrated into the battery management system. The power circuit includes a bidirectional dc-dc power converter, a matrix-switch power converter, and an auxiliary energy storage unit capable of exchanging energy with each cell of the battery segment. The master control manages the feedback signals from the battery management system, such as cell voltage and power required/provided by/from the battery pack of the electric vehicle system, and decides which of the following slave operations should be activated: (i) equalization control algorithm with adjustable current using genetic algorithms, (ii) cell energy support control algorithm with adjustable current, or (iii) algorithm for estimation of the resistance and state-of-health of each cell based on the Electrochemical Impedance Spectroscopy (EIS) technique.

FIGURE 2

**Description**

**The scope of application of this invention**

This invention relates to a method for regulating the equalization and energy support currents in Battery Energy Storage Systems (*BESS*). Specifically, the equalization current of each cell is determined by seeking an optimal balance between the cell equalization speed of the *BESS,* the energy losses of the *dc-dc* equalization converter, and the residual available energy (*RAE*) according to the priorities set by the battery system designer. The current during the operation of energy support for the *BESS* cells is determined based on the energy requirements of the vehicle's motor during dynamic operation and the energy capability of each battery cell, in order to support the weakest cells and ensure satisfactory management of the dynamic state. The equalization and energy support systems are enhanced by an Auxiliary Energy Storage Unit (*AESU*), which is utilized to temporarily store/recover electric energy to/from any cell of the main battery pack. The equalization current determination algorithm is implemented using a Genetic Algorithm (*GA*), while the energy support current is regulated through a Proportional-Integral (*P1*) control system.

Batteries are the most popular energy storage technology for electric power applications, primarily in electric vehicles. Due to the growing interest, significant studies have been conducted to improve their performance and lifespan. Lithium-ion (Li-ion) batteries have dominated the electric vehicle systems due to their high energy and power density, fast charging and discharging capabilities, and a large number of full charge-discharge cycles.
The battery pack of an electric vehicle usually consists of multiple batteries, mostly lithium-ion, connected in series to meet the required voltage range. Since the technical characteristics of battery cells may differ, such as capacity and impedance, an imbalance in the operation of the cells during charge-discharge processes can occur. This results in the reduction of the residual available capacity (*RAC*) and the performance of the battery cells. Additionally, the absence of a cell equalization system can lead to overvoltage and consequently overheating in some battery cells. Therefore, an optimal equalization system can not only improve the performance of the battery cells but also protect their lifespan during both charging and discharging operations.

**Technical level**

For monitoring and managing Energy Storage Systems (*ESS*), various inventions have been proposed in the past. In US 2020287395A1, dated September 10, 2020, a method for managing the energy of a hybrid *ESS* with batteries and supercapacitors is presented, taking into account the power level during charging/discharge operations. Specifically, during high-power charging of the *ESS,* priority is given to the supercapacitors over the batteries, while during low-power charging, priority is given to the batteries. Similarly, during discharge operation, the supercapacitors provide their energy first, followed by the batteries. The aforementioned method constitutes an energy management system that controls the stored energy of an *ESS.* However, it does not perform cell equalization or provide energy support to weak cells.

In US2019195956A1, dated June 27, 2019, a method for determining the State of Charge (*SoC*) and State of Health (*SoH*) of battery cells is presented. However, no equalization method or energy support algorithm for battery cells is proposed.

KR102111412B1, dated May 15, 2020, focuses on controlling the operation of an *ESS* consisting of three storage media (lead-acid batteries, lithium-ion batteries, and supercapacitors), defining the magnitude of the *ESSs* current variation as the main control criterion.

In CN 110808627A, dated February 18, 2020, a control method for hybrid ESS is proposed, where the supercapacitor pack manages high power variation, while the battery pack is involved in the operation during low power variations. Additionally, a method for protecting the battery pack by controlling the maximum charging/discharging power is presented. However, no equalization system or energy support system for battery cells is proposed.

In CN110797959A, dated February 14, 2020, a control method for a hybrid *ESS* with batteries and supercapacitors is proposed to maintain the DC voltage of the common node at desired levels. However, there is no cell equalization system.

In EP3333008A1, dated June 13, 2018, a battery cell equalization system is proposed. To achieve battery equalization, the proposed system allows energy exchange between cells, based on the State-of-Charge (*SoC*) and state-of-Health (*SoH*) of each cell. However, the presented method does not include current control algorithm during equalization process and does not propose an energy support system for the weakest cells of the segment.

In US2022224129A1, dated July 14, 2022, a system and method for charging and discharging battery segments are presented. Specifically, a system and method are provided for minimizing battery cell overcharging while achieving fast charging cycles. Additionally, an overvoltage protection circuit is presented to address situations involving internal short circuits in the battery or short circuits across the entire segment. Furthermore, a charging current determination system is proposed for the *BESS based* on the *SoH* of each segment. However, the presented method does not include an algorithm for controlling the current of each cell in the battery segment during equalization.

In CN109428361A, dated March 5, 2019, the equalization of adjacent battery cells is achieved through power circuits controlled by a fuzzy logic system based on cell voltage measurements. However, the battery equalization is only performed with respect to adjacent cells, resulting in reduced equalization speed and effectiveness.

In CN206422545U, dated November 30, 2017, a method for battery cell equalization in electric vehicles is proposed. In this method, each battery cell is directly connected to a supercapacitor, and energy exchange occurs through power circuits without determining the magnitude of the equalization current.

In CN105656142A, dated June 8, 2016, a hybrid cell equalization system is proposed, incorporating batteries and supercapacitors, allowing energy exchange between remote cells. However, there is no method to support problematic cells, and the equalization current is not determined for each individual cell.

In CN105322560A, dated February 10, 2016, a hybrid cell equalization circuit with batteries and supercapacitors is presented. However, energy support for the equalization process is applied to the entire set of cells and not to individual cells. Additionally, GR1010317, dated September 15, 2021, presents a battery cell equalization system assisted by a segment of supercapacitors. However, the equalization current value is not regulated.

In US2020244074A1, dated July 30, 2020, a system and method for battery charging control are proposed. Specifically, the control method operates only during the charging process and determines the battery charging current based on the *SoC* and *SoH* without considering the equalization circuit losses and the equalization speed.

In EP4102239A1, dated December 14, 2022, a device and method for controlling and determining the participation of battery cells in the equalization process are presented. However, a method for controlling the equalization current of each cell and a support system for the battery cells have not been proposed.

In WO2021256638A1, dated December 23, 2021, a system for managing an *ESS* is proposed, consisting of a battery operation monitoring system, battery parameter estimation system, overcharge and over-discharge protection system, and an equalization system. However, the proposed method does not adjust the equalization current of each battery cell.

In US2016187427A1, dated June 30, 2016, a system for estimating the current flowing through the cells of a battery segment is presented by considering the voltage of the entire segment, as well as the voltage and resistance of each cell. In KR102201988B1, dated January 12, 2021, an energy management system for ESSis proposed, consisting of an equalization system and a cell protection system for each segment based on estimations of *SoC* and *SoH.*

In WO2006057468A1, dated June 1, 2006, a method and system for estimating cell parameters in a battery segment are presented without performing equalization or energy support methods.

The CN103795123A, dated May 14, 2014, presents an equalization system for a hybrid *ESS* with lithium-ion batteries and supercapacitors. This system features bidirectional energy flow, as well as protection and monitoring of the hybrid *ESSs* operation. However, the connection of the batteries to the supercapacitors is done directly without a buck/boost circuit, resulting in the incapability to determine the optimal equalization current for each cell. Additionally, the supercapacitors do not participate in providing energy support to the weak cells of the battery pack.

In CN103532193A, dated January 22, 2014, an equalization system is proposed for an electric vehicle with two battery packs and one supercapacitor pack. This system connects each cell of the first battery pack to one or more supercapacitor cells, while the second battery pack is exclusively used for the equalization process. To achieve the equalization of a combined battery cell/supercapacitor system, a bidirectional *dc-dc* power converter is used, allowing its connection to the second battery pack. The above implementation does not present an equalization method for the second battery pack, and the optimal equalization current for each cell is not determined.

CN103023107A, dated April 3, 2013, proposes an equalization system for a hybrid ESSwith a battery pack and a supercapacitor pack. The supercapacitor serves as a temporary energy storage system during the equalization process. However, a method for determining the optimal equalization current for each battery cell is not presented, and the supercapacitor is not involved as an energy support mean during dynamic operation to assist weak cells.

In US2017214252A1, dated July 27, 2017, a battery pack equalization system supported by an intermediate energy storage medium is presented. The energy storage medium is connected to each battery of the pack through an isolated dc-dc power converter. In this topology, each battery in the pack has its own power converter; however, a method for determining the equalization current is not proposed.

KR101827961B1, dated February 13, 2018, proposes an equalization system for a hybrid ESSwith batteries and supercapacitors. The equalization circuit consists of a flyback power converter with a transformer, resulting in increased volume of the final application. Additionally, the equalization current is not regulated.

In CN112486020, dated March 12, 2021, a predictive control technique is presented for a hybrid ESSwith lithium-based batteries and supercapacitors. This technique achieves a reduction in the maximum operating current and protects the battery lifespan. However, a cell equalization technique for the battery pack is not proposed.

Various techniques for battery cell equalization have been proposed in several technical journals. Specifically, in the work of Y. Zheng, M. Ouyang, L. Lu, J. Li, X. Han, and L. Xu, entitled "Online equalization for Lithium-Ion battery packs based on charging cell voltages: Part 2. fuzzy logic equalization," published in J. Power Sources, vol. 247, pp. 460-466, Feb. 2014, a method based on connecting passive elements (resistors) in parallel with each battery cell is presented. Additionally, a dissipative equalization method using resistors and a switching element to control the equalization of each cell separately has been proposed by T. Stuart and W. Zhu in their paper entitled "Fast equalization for large lithium-ion batteries," published in IEEE Trans. Aerosp. Electron. System, vol. 24, no. 7, pp. 27-31, July 2009.

Active equalization arrangements have attracted significant attention within the scientific community. Specifically, a method for controlling battery cell equalization using MOSFETs and capacitors as intermediate energy transfer media between cells has been presented by Y. Shang, B. Xia, Fei Lu, C. Zhang, N. Cui, and C. Mi in their paper entitled "A Switched-Coupling-Capacitor Equalizer for Series-Connected Battery Strings," published in IEEE Trans. Power Electron., vol. 32, no. 10, pp. 7694-7706, Dec. 2016. Additionally, a system for direct adjacent cell equalization through power converters has been proposed by M. Kauer, S. Narayanaswamy, S. Steinhorst, and S. Chakraborty in their paper entitled "Rapid Analysis of Active Cell Balancing Circuits," published in IEEE Trans. Computer-Aided Design of Integrated Circuits and Systems, vol. 36, no. 4, pp. 694-698, Apr. 2017. Furthermore, an active equalization topology where a transformer serves as an intermediate energy transfer medium between cells has been introduced by K.-M. Lee, S.-W. Lee, Y.-G. Choi, and B. Kang in their paper entitled "Active Balancing of Li-Ion Battery Cells Using Transformer as Energy Carrier," published in IEEE Trans. Ind. Electron., vol. 64, no. 2, pp. 1251-1257, Feb. 2017.

A method for increasing the efficiency of an equalization system for battery or supercapacitor cells has been presented in Y. Yuanmao, K. W. E. Cheng, and Y. P. B. Yeung's paper entitled "Zero-current switching switched-capacitor zero-voltage-gap automatic equalization system for series battery string," published in IEEE Trans. Power Electron., vol. 27, no. 7, pp. 3234-3242, Jul. 2012. However, this method only performs equalization between adjacent cells, resulting in a slow equalization process. In the work of T. Hartley, I. Husain, entitled "A Battery Management System Using an Active Charge Equalization Technique Based on a DC/DC Converter Topology," published in IEEE Trans. Ind. Appl., vol. 49, no. 6, pp. 2720-2729, Dec. 2013, an active equalization system through a *dc-dc* power converter is presented, which operates only during battery charging.

A technique for battery cell equalization in electric vehicle applications that utilizes a *dc-dc* power converter in combination with a matrix-switch power converter and a supercapacitor pack has been proposed in the article of N. Jabbour, E. Tsioumas, N. Karakasis, and C. Mademlis entitled "Improved Monitoring and Battery Equalizer Control Scheme for Electric Vehicle Applications," presented at the IEEE International Conference SDEMPED'2017, Tinos, Greece. However, the presented method does not control the equalization current. Additionally, a technique for monitoring and equalizing the cells of a hybrid *ESS* with batteries and supercapacitors for electric motor applications has been presented in the article of N. Jabbour, E. Tsioumas, M. Koseoglou, and C. Mademlis entitled "Highly Reliable Monitoring and Equalization in a Hybrid Energy Storage System with Batteries and Supercapacitors for Electric Motor," presented at the IEEE International Conference SPEC'2018, Singapore. However, the equalization current is determined by the user without applying any optimal adjustment method.

The amplitude of the equalization current plays a crucial role in achieving optimal battery operation and protecting its lifespan. Typically, it is chosen based on the technical characteristics of the battery elements and maintained constant throughout the battery's operation, as suggested in the research papers Z. Wei, F. Peng, and H. Wang, "An LCC-Based String-to-Cell Battery Equalizer With Simplified Constant Current Control," IEEE Trans Power Electron, vol. 37, no. 2, pp. 1816-1827, 2022, and Z. Wei, H. Wang, Y. Lu, D. Shu, G. Ning, and M. Fu, "Bidirectional Constant Current String-to-Cell Battery Equalizer Based on L2C3 Resonant Topology," IEEE Trans Power Electron, vol. 38, no. 1, pp. 666-677, 2023.

Additionally, in the work of S. Jinlei, L. Wei, T. Chuanyu, W. Tianru, J. Tao, and T. Yong, "A Novel Active Equalization Method for Series-Connected Battery Packs Based on Clustering Analysis With Genetic Algorithm," IEEE Trans Power Electron, vol. 36, no. 7, pp. 7853-7865, 2021, the maximum charging current is chosen as the equalization current. In the work of H. Zhang, Y. Wang, H. Qi, and J. Zhang, "Active Battery Equalization Method Based on Redundant Battery for Electric Vehicles," IEEE Trans Vehicular Technology, vol. 68, no. 8, pp. 7531-7543, 2019, the equalization current is arbitrarily selected.

Several research efforts have been conducted to regulate the equalization current in real-time. Specifically, a technique for adjusting the equalization current of each battery cell based on its capacity is presented in the work of M. Einhorn et al., "A Current Equalization Method for Serially Connected Battery Cells Using a Single Power Converter for Each Cell," IEEE Trans Veh. Technol, vol. 60, no. 9, pp. 4227-4237, 2011. However, the equalization speed is not taken into account. An equalization strategy that adjusts the current of each cell in real-time considering its model and the *RAE* is proposed in the work of W. Diao, N. Xue, V. Bhattacharjee, J. Jiang, O. Karabasoglu, and M. Pecht, "Active battery cell equalization based on residual available energy maximization," Appl Energy, vol. 210, pp. 690-698, 2018. However, the battery model parameters are not updated in real-time, and the losses of the equalization circuit are not considered.

In the work of F. S. J. Hoekstra, H. J. Bergveld, and M. C. F. Donkers, "Optimal Control of Active Cell Balancing: Extending the Range and Useful Lifetime of a Battery Pack," IEEE Transactions on Control Systems Technology, vol. 30, no. 6, pp. 2759-2766, 2022, although the power losses of the equalization converter are considered in the algorithm for regulating the cell's equalization currents, the equalization speed is not considered. Finally, a cell equalization technique based on predictive control models is proposed in the work of Y.-X. Wang, H. Zhong, J. Li, and W. Zhang, "Adaptive estimation-based hierarchical model predictive control methodology for battery active equalization topologies: Part I-Balancing strategy," J Energy Storage, vol. 45, p. 103235, 2022. This technique takes into account the losses of the equalization circuit and the equalization speed. However, the parameters of each cell's model are not updated in real-time, and a system for energy support of the weak cells is not proposed.

### Aim of the invention

From the above, it is concluded that an improved equalization strategy is required, which can adjust the equalization current for each battery cell in real-time, taking into account the most significant parameters that affect the equalization process. These parameters are the equalization speed, power converter losses, and the *RAE* of each cell. The equalization method should monitor the performance of each battery cell in real-time in order to determine the appropriate equalization current based on the optimal balance between the aforementioned parameters. The implementation of the above system should be done according to the priorities set by the designer of the battery management system.

### Description of the invention

In the present invention, the above are accomplished through an equalization method based on Genetic Algorithms (*GA*) and utilizing an *AESU* that contributes to the equalization process by providing energy support to any weak cells in the battery pack. The *AESU* can be either another segment of battery cells or a segment of supercapacitors. Additionally, the proposed method of the present invention monitors the state of charge and health of each battery cell through its internal resistance and *SoH* parameter, using the electrochemical impedance spectroscopy (EIS) technique. The proposed combined cell-to-cell equalization and energy support system is realized through a master-slave control scheme. Specifically, the main (master) control algorithm supervises the overall operation of the combined battery system for each battery segment, while the dependent (slave) control algorithms for equalization, energy support, and parameter estimation are performed on each cell of the battery pack.

The invention presents:

(a) A combined online adjustable current control scheme for cell-to-cell equalization and energy support utilizing an *AESU* is proposed. The suggested Battery Management System (*BMS*) scheme can be applied to both charge and discharge mode.

(b) The equalization algorithm is implemented utilizing the GA technique and regulates the equalization current of each battery cell by finding, according to the designer priorities, an optimal balance between the most important parameters that affect the cell equalization performance, i.e., equalization speed, energy loss of the equalization *dc-dc* converter, and the residual available energy.

(c) The energy support method is realized with a scheme of two *PI* controllers in cascaded mode and decides which cell is weak and needs energy support by the *AESU* and then regulates the current with which the energy support procedure is performed.

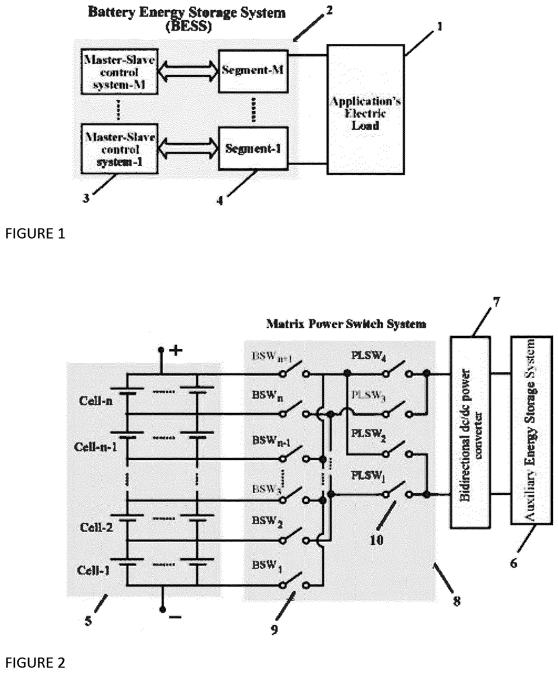

(d) The estimation method of the impedance and *SoH* of each cell in the segment is based on the *EIS* technique. Through the estimation method, the model of each cell is updated, leading to improved performance of the aforementioned methods. The overall system in which the proposed method of the present invention operates is illustrated in Figure 1. It consists of the application's electrical load [1] and the *BMS* [2], which comprises *M*-segments of *N*-cells each one [4], where each segment is controlled by its own master-slave system [3]. Each master-slave system has its own power circuit, as depicted in Figure 2, where the proposed method of the present invention is applied.

The circuit presented in Figure 2 has two objectives: (a) to equalize the cells within each segment and (b) to assist any weak cell or cells with low *SoH* during high dynamic operations and/or when their voltage reaches the low safety threshold. Each battery cell in the segment [5] is connected to the BMS [6] through a circuit comprising a bidirectional *dc-dc* converter [7] and a matrix-switch power converter (*MSPC*) [8]. The MSPC consists of two sets of switches: the cell switches (*BSW*) [9] and the polarity switches (*PLSW*) [10]. If cell *i* should be connected to the *BMS*, switches $BSW_i$ and $BSW_{i+1}$ should be activated. Additionally, if *i* is an odd number, switches $PLSW_2$ and $PLSW_3$ should be activated; otherwise, switches $PLSW_1$ and $PLSW_4$ should be activated.

The nominal values of the power rating of the *BMS* [6], bidirectional *dc-dc* power converter [7], and *BSW* [9] and *PLSW* [10] switches should be appropriately selected so that the potentially weakest cell in the segment can be adequately supported during high dynamic operations of the main application [1] or if the cell voltage reaches the low safety threshold. Additionally, the switching frequency of the *dc-dc* power converter [7] should be much higher compared to the switching frequency of *BSW* [9] and *PLSW* [10].

Since multiple cells are connected in series to form a pack of the battery, the voltage of each cell (e.g., the *i*-th cell belonging to the *j*-th segment) at time *t* is given by the equation:

$$V_c^i = V_{oc}^i - V_R^i - \sum_{l=1}^{N_p} V_{P,l}^i \qquad (1)$$

where $V_{oc}^i$ is the open-circuit voltage, $V_R^i$ is the ohmic voltage, $N_p$ is the number of the RC elements and $V_{P,l}^i$ is the polarization voltage of the *i*-th RC element. Since the polarization and the ohmic resistances can be included into the cell internal resistor $R_c^i$ which depends on its SoC$^i$ and temperature $T_c^i$, the voltage $V_c^i$ can be expressed as:

$$V_c^i = V_{oc}^i - I_c^i \cdot R_c^i(\text{SoC}^i, T_c^i) \qquad (2)$$

where $I_c^i$ is the current of the *i*-th cell. This means that the cell voltage is influenced by the current and thus, it might reach the cut-off voltage threshold earlier than its open circuit voltage. In this case, at the discharge mode, the Battery Storage System (*BSS*) disconnects the whole segment from the battery pack to protect this cell, even though may be available energy in the other cells of the segment and they could provide energy to the application. For similar reasons, during the charging operation, the BSS disconnects the segment from the battery pack, even though this cell as well as the other cells of the battery segment may not be fully charged.

From the above it is revealed that the current has a crucial role on the proper operation of, not only some individual cells, but the whole battery pack. The current $I_c^i$ is given by

$$I_c^i = I_{seg}^j - I_{eq}^i \qquad (3)$$

Since the load current $I_{seg}^j$ depends on either the charging control strategy or the application requirements at the discharge mode, the responsibility to regulate the total current so as maximum exploitation of each battery cell can be attained is moved to the equalization current. Therefore, the proper control of the amplitude of each cell equalization current is important to ensure satisfactory performance of the whole battery pack and this can be attained through an improved equalization algorithm by online considering each cell operating conditions.

The main (master) control determines, based on the operating conditions of each cell and the energy requirement of the motor drive system, which of the following dependent (slave) functions should be activated. These functions include the energy support subsystem with adjustable current for any weak cell in the segment, cell-to-cell equalization subsystem with adjustable current, or estimation of cell parameters subsystem. Specifically, the role of the main (master) control is to make real-time decisions on which of the above control functions should be activated, taking into account the power needs of the application's load, the voltage of the BMS, and the residual available capacity (RAC) of each cell in relation to the corresponding boundary values defined by the system administrator.

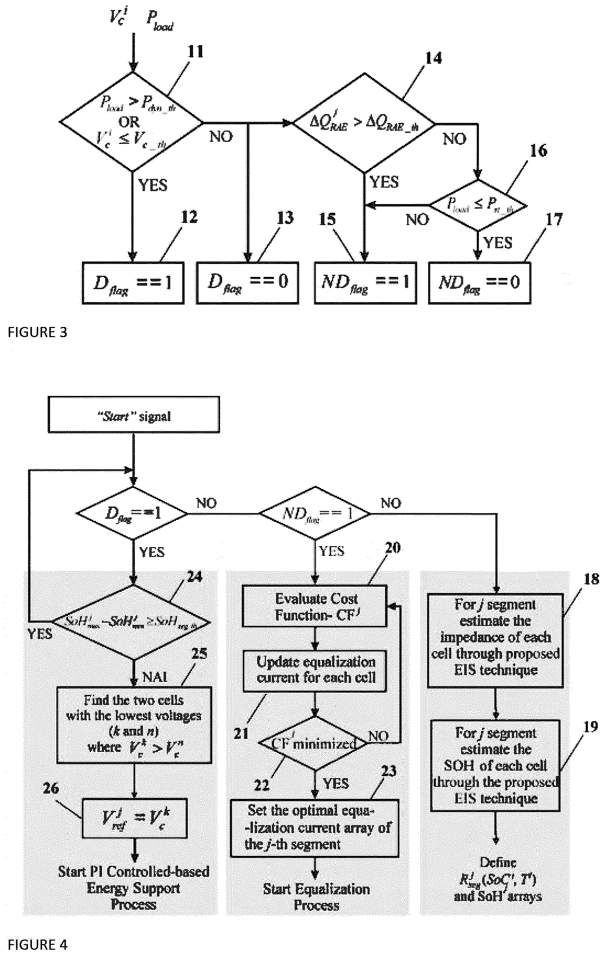

The operation of the master algorithm is described in Fig. 3. Specifically, at [11], it is checked whether the power need of the electric load by the battery, $P_{load}$, is higher than a threshold value $P_{dyn\_th}$ (i.e., $Pload > P_{dyn\_th}$) which has been defined by the system administrator, and if this holds, dynamic operation of the battery is considered and the $D_{flag}$ is activated [12]. This flag initiates the energy support algorithm to assist any potential weak cells through the AESU. The $D_{flag}$ is also activated (i.e., $D_{flag} == 1$) if the voltage of at least one cell of the battery segment $V_c^i$ reaches the lowest voltage safety threshold $V_{c\_th}$ during the discharging operation (i.e., $V_c^i \leq V_{c\_th}$), otherwise the $D_{flag}$ is deactivated (i.e., $D_{flag} == 0$) [13]. If none of the above situations occur, the master algorithm identifies if the battery cells need equalization, or the cells' parameters estimation process can start. Specifically, in [14], if the discrepancies in the residual available capacity of at least one cell of the $j$-th segment $\Delta Q_{RAE}^{j}$ is greater than a discrepancy threshold value $\Delta Q_{RAE,th}$ (i.e.,

$\Delta Q_{RAE}^{j} \geq \Delta Q_{RAE\_th}$ ), the $ND_{flag}$ is activated (i.e., $ND_{flag} == 1$) [15] and the equalization process with adjustable current is energized. Contrarily, in [16], if the discharge load power $P_{load}$ is less or equal than a steady-state threshold value $P_{st\_th}$ (i.e., $P_{load} \leq P_{st\_th}$), it is concluded that battery segment is in steady-state operation and thus, cell equalization is not needed. This means that there are the appropriate conditions for the cell parameters estimation algorithm, and thus, the slave method of cell parameter estimation is initiated. Hence, the $ND_{flag}$ flag is deactivated (i.e., $ND_{flag} == 0$) [17]. Otherwise, the $ND_{flag}$ flag remains active [15], and the cell equalization is continued.

The operation of the slave control scheme is shown in Figure 4. The dependent (slave) control method for parameter estimation utilizes two methods that employ the EIS technique to estimate the internal resistance $R_c$ [18] and $SoH$ [19] of each cell. The above parameters are used by the cell equalization and energy support algorithms. The internal resistance of each cell is estimated by considering the temperature, current and voltage measurements. Thus, an array is formed with the internal resistances of all cells of the $j$-th segment, with respect to their $SoC$ and temperature, as the following

$$R_{seg}^{j} = \begin{bmatrix} R_c^1(SoC^1,T_c^1) & R_c^2(SoC^2,T_c^2) & \cdots & R_c^N(SoC^N,T_c^N) \end{bmatrix} \quad (4)$$

The $SoH$ of each cell of the $j$-th segment can be estimated by utilizing an $EIS$-based technique that considers the temperature and $SoC$, and thus, the $SoH$ array of the $j$-th segment is formed as follows

$$SoH_{seg}^{j} = \begin{bmatrix} SoH_c^1 & SoH_c^2 & \cdots & SoH_c^N \end{bmatrix} \quad (5)$$

In the present invention, cell-to-cell equalization technique based on the residual available capacity is adopted since it is satisfactorily accurate and has reduced computational time and low energy consumption performance. The equalization current is controlled in real-time, seeking an optimal balance among the most significant parameters that affect battery cell equalization, while taking into consideration the importance assigned by the system administrator to equalization speed, losses in bidirectional $dc$-$dc$ power converter, and $RAE$.

If the $i$-th cell is involved in the equalization process, its duration can be calculated by

$$\Delta t_{eq}^{i} = \frac{|\Delta Q_c^i|}{|I_c^i|} \quad (6)$$

where $\Delta Q_c^i$ is the change of the $i$-cell capacity at either charging or discharging mode, otherwise $\Delta t_{eq}^i = 0$. Thus, an array with each cell equalization time of the $j$-segment is formed as follows

$$\Delta T_{eq}^{j} = \begin{bmatrix} \Delta t_c^1 & \Delta t_c^2 & \cdots & \Delta t_c^N \end{bmatrix} \quad (7)$$

and therefore, the total equalization time of the $j$-segment is given by

$$\Delta t_{eq,total}^{j} = \sum_{i=1}^{N} \Delta t_{eq}^{i} \quad (8)$$

As shown in Figure 2, the equalization system consists of a bidirectional $dc$-$dc$ converter [7] and a matrix switch power converter [8]. The total efficiency of the two converters depends on the amplitude of the equalization current. Specifically, during the boost operation of the *dc-dc* converter where energy is transferred from the *i*-th cell to the AESU, the energy loss can be calculated by

$$E_{loss,boost}^i = \left[1 - \eta_{boost}(I_{eq}^i)\right] E_c^i \quad (9)$$

where $\eta_{boost}$ is the efficiency of the equalization circuit at the boost operation and $E_c^i$ is the excess energy that is absorbed by the *i*-th cell during the equalization process. Similarly, at the buck operation of the *dc-dc* converter [7] where energy is transferred from the AESU to the *i*-th cell, the energy loss can be estimated by

$$E_{loss,buck}^i = \left[1 - \eta_{buck}(I_{eq}^i)\right] E_{AES}^i \quad (10)$$

where $\eta_{buck}$ is the efficiency of the equalization circuit at the buck operation and $E_{AES}^i$ is the energy that is transferred from the AESU to the *i*-th battery cell. Thus, two arrays of the power loss per each cell of the *j*-segment are formed, when energy is transferred to and from the AESU, respectively, as follows

$$E_{loss,boost}^j = \left[ E_{loss,boost}^1 \quad E_{loss,boost}^2 \quad \cdots \quad E_{loss,boost}^N \right] \quad (11)$$

$$E_{loss,buck}^j = \left[ E_{loss,buck}^1 \quad E_{loss,buck}^2 \quad \cdots \quad E_{loss,buck}^N \right] \quad (12)$$

Thus, the total energy loss of the *j*-segment during the equalization process is given by

$$E_{loss,total}^j = \sum_{i=1}^{N} E_{loss,boost}^i + \sum_{i=1}^{N} E_{loss,buck}^i \quad (13)$$

The initial SoC of the *i*-th cell is a function of the open circuit voltage

$$SoC_{init}^i = f(V_{oc}^i) \quad (14)$$

and the SoC at the time instant t is given by

$$SoC^i = SoC_{init}^i + \frac{\int_0^t I_c^i dt}{Q_{nom}^i} \quad (15)$$

where $Q_{nom}^i$ is the nominal capacity of the *i*-th cell. Thus, the residual available capacity of the *i*-cell at the time instant *t* is given by

$$Q_{RAC}^i = SoC^i \cdot Q_{nom}^i \quad (16)$$

and the residual available capacity of the whole *j*-segment, where the *N* cells belong, is

$$Q_{RAC} = \min_{1 \leq i \leq N} Q_{RAC}^i \qquad (17)$$

Therefore, the minimum *SoC* of each *i*-cell of the *j*-segment as a function of the residual available capacity can be determined by

$$SoC_{\min}^i = SoC_{init}^i - \frac{Q_{RAC}^j}{Q_{nom}^i} \qquad (18)$$

From (18), the residual available energy of each *i*-cell, for the time instant that corresponds to $SoC_{init}^i$ up to the time instant where $SoC_{\min}^i$ , can be estimated by

$$E_{RAE}^i = \left( \int V_{oc}^i I_c^i dt - \int I_c^{i^2} R_c^i (SoC^i, T_c^i) dt \right) \Big|_{SoC^i = [SoC_{\min}^i \ \ SoC_{init}^i]} \qquad (19)$$

and therefore, the residual available energy of the *j*-segment is given by

$$E_{RAE,total}^j = \sum_{i=1}^N E_{RAE}^i \qquad (20)$$

As can be seen by (19) and (20), the maximization of the residual available energy of any segment of a battery pack is directly affected by the load current of each cell and more specifically, as resulted by (3), it is strongly correlated with the equalization current.

From the above it is concluded that the residual available energy, the energy loss of the equalization circuit, and the equalization time are the three main parameters that should be optimized based on the proposed *GA*-based strategy. Specifically, high cell residual available energy, reduced energy loss in the energy conversion during the equalization process and reduced equalization time are required. However, since the above objectives cannot be simultaneously satisfied, an optimal balance should be found between them, through which the equalization current of each *i*-cell can be determined. This can be accomplished by utilizing the *GA* technique and specifically, through the minimization of the following cost function

$$CF^j = w_1 \cdot \frac{E_{RAE,\max}^j}{E_{RAE,total}^j} + w_2 \cdot \frac{E_{loss,total}^j}{E_{loss,\max}^j} + w_3 \frac{\Delta t_{eq,total}^j}{\Delta t_{eq,\max}^j} \qquad (21)$$

where $E_{RAE,\max}^j$ , $E_{loss,\max}^j$ , and $\Delta t_{eq,\max}^j$ are the maximum residual available energy, the energy loss in the equalization circuit, and the equalization time, respectively, of the *j*-segment. The $w_1$, $w_2$ and $w_3$ are the weighting factors for the residual available energy, the equalization circuit loss, and the equalization time, respectively ($w_1$ + $w2$ + $w_3$ = 1), that are decided by the system administrator according to the priorities that should be given to the aforementioned objectives. Thus, in the slave control unit of the cell equalization method with adjustable current, the cost function *CF* of equation (21) is evaluated at the control level [20]. Then, at the control level [21], the equalization currents of the battery cells are adjusted, and if *CF* is minimized [22], the final equalization currents for each cell of the *j*-th segment are determined [23]. Otherwise, the control flow returns to [20].

At each *j*-segment, the energy support algorithm monitors the *SoH* of each cell by the array (5). The energy support system is activated when the difference between the highest and the lowest *SoH* values of the *j*-segment cells is greater than a predefined threshold value, $SoH_{max}^j - SoH_{min}^j \geq SoH_{seg,th}$ [24]. Then, the two cells of the segment with the lowest voltage are found (let these are the k-th and *n*-th cells, where $V_c^k > V_c^n$ [25]). The cell with the lowest voltage (*n*-th cell) can be supported by the AESU and thus, the reference voltage of the *PI* controller of the energy support system gets the value of the *k*-th cell voltage of those two cells, $V_{ref}^j = V_c^k$ [26].

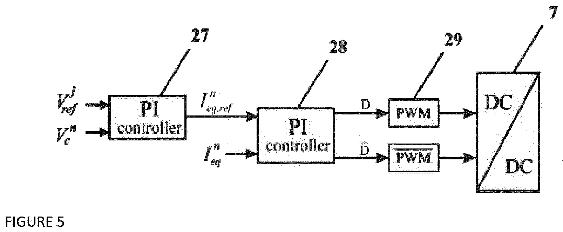

The energy support control system with adjustable current for cell *n* of the *j*-segment, selected at [25] (Figure 4), indicating the need for energy support, is illustrated in Figure 5. From the *PI* controller [27] which has as inputs the $V_{ref}^j$ that is determined by $V_{ref}^j = V_c^k$ [26] and the $V_c^n$ which is the lowest voltage of all the cells of the *j*-segment, the reference equalization current is obtained $I_{eq,ref}^n$. Then, from the $I_{eq,ref}^n$ and the actual equalization current, and through another *PI* controller [28], the PWM pulses [29] of the *dc-dc* controller [7] are provided.

**Claims**

1. Cell equalization method with energy support to weak cells or cells with low state of health (*SoH*) value, consisting of a main (master) and three dependent (slave) control algorithms implemented using a system composed of a battery pack [5] and an Auxiliary Energy Storage Unit (*AESU*) [6] which is connected to the battery pack through a circuit composed of a bidirectional *dc-dc* converter [7] and a matrix-switch power converter (*MSPC*) [8] equipped with a set of cell switches (BSW) [9] and a set of polarity switches (PLSW) [10], and is **characterized by** the fact that

   i. *The main (master) control algorithm* manages the feedback signals of the battery management system and decides which of the following dependent (slave) controls, ii, iii, and iv, will be activated,
   ii. *The first dependent (slave) control algorithm* is an energy support algorithm with adjustable current, implemented through a series topology of two PI controllers that determines which cell is the weakest and requires energy support utilizing the Auxiliary Energy Storage Unit (AESU) and also regulates the current of the weakest cell,
   iii. *The second dependent (slave) control algorithm* is an equalization control algorithm with adjustable current, implemented using the technique of Genetic Algorithms (GA) that adjusts the equalization current of each cell by finding an optimal balance, based on the designer's priority weights, among the most significant parameters that affect battery cells equalization performance, i.e. equalization speed, power losses of the equalization circuit, and the residual available energy (RAE) of each cell,
   iv. *The third dependent (slave) operation* is the estimation of cell parameters, specifically the impedance and state of health (SoH) of each cell, based on the Electrochemical Impedance Spectroscopy (EIS) technique and updates the model of each cell, thereby enhancing the operation of the aforementioned slave controls (ii) and (iii).

2. Cell equalization method, according to claim 1(i), **characterized by** the fact that the main (master) control algorithm verifies whether the primary system application is in dynamic operation or if there is a weak cell in the battery segment. If at least one of these two cases is true, the flag $D_{flag}$ is activated ($D_{flag}$ == 1) and correspondingly is activated the dependent (slave) control algorithm of the energy support with adjustable current (slave method ii of claim 1). If neither of the two aforementioned cases is true, the flag $D_{flag}$ remains deactivated ($D_{flag}$ == 0) and the main (master) control algorithm proceeds to the next check, where it verifies if the cells in the segment require equalization and then, the flag $ND_{flag}$ is activated ($ND_{flag}$ ==1) and correspondingly activates the dependent (slave) control algorithm of equalization with adjustable current (dependent slave control iii of claim 1) or performs an estimation of the cell parameters and in this case the $ND_{flag}$ remains inactive ($ND_{flag}$ == 0) and the operation for estimating the impedance and state of health of each cell is activated (slave method iv of claim 1).

3. Cell equalization method, according to claims 1(i) and 2, **characterized by** the fact that the $D_{flag}$ flag ($D_{flag}$ == 1) and , correspondingly, the dependent (slave) control of energy support with adjustable current (dependent control ii of claim 1) are activated either if the power of the motor drive system's load, $P_{load}$, exceeds a threshold value defined by the system administrator $P_{dyn\_th}$ (i.e., $P_{load} > P_{dyn\_th}$ ), or if the voltage of at least one cell in the segment $V_{c\_th}$ (let's say cell *i*) is equal to or less than the value of the low safety threshold voltage during discharge operation (i.e., $V_c^i \leq V_{c\_th}$ ).

4. Cell equalization method, according to claims 1(i) and 2, **characterized by** the fact that the $N_{Dflag}$ flag ($ND_{flag}$ == 1) is activated and, correspondingly, the dependent (slave) equalization control algorithm with adjustable current (dependent control iii of claim 1) is activated if the difference between the residual available energy of the healthiest cell in the segment and the less healthy cell in the segment $\Delta Q_{RAE}$ is greater than a predetermined threshold deviation value $\Delta Q_{RAE\_th}$ (i.e., $\Delta Q_{RAE} > \Delta Q_{RAE\_th}$).

5. Cell equalization method, according to claims 1(i) and 2, **characterized by** the fact that the $ND_{flag}$ flag remains inactive ($ND_{flag}$ == 0) and, correspondingly, the estimation function of the impedance and the $SoH$ of each cell is activated (slave method iv of claim 1), if the load power of the main application $P_{load}$ is equal to or less than a predetermined power threshold value (i.e., $P_{load} \leq P_{st\_th}$) and if the difference between the residual available energy of the healthier cell in the segment and the less healthy cell in the segment $\Delta Q_{RAE}$ is less than or equal to a predetermined deviation threshold value $\Delta Q_{RAE\_th}$ (i.e., $\Delta Q_{RAE} \leq \Delta Q_{RAE\_th}$).

6. Cell equalization method, according to claim 1(ii), **characterized by** the fact that the dependent (slave) control algorithm of energy support with adjustable current, which is activated when $D_{flag}$ ==1 is satisfied according to claims 2 and 3, monitors the $SoH$ of each cell. If the difference between the highest $SoH_{max}$ and the lowest $SoH_{min}$ value among the cells of the segment (let's say of segment $j$) is greater than a predetermined threshold value $SoH_{seg,th}$ (i.e., $SoH_{max}^{j} - SoH_{min}^{j} \geq SoH_{seg,th}^{j}$ ), the two cells of the segment (let's say cells $k$ and $n$) with the lowest voltage are identified, where $V_c^k > V_c^n$ , and the cell with the lowest voltage (cell $n$) is selected to be supported by the *AESU,* setting the voltage of the cell with the highest voltage (cell $k$) as the reference voltage in the system of the two proportional-integral ($P1$) controllers, namely $V_{ref} = V_c^k$ .

7. Cell equalization method, according to claims 1(ii), 2, and 6, the system of the two *PI* controllers controls the operation of the bidirectional dc-dcconverter [7], where the inputs of the first *PI* controller [27] are $V_{ref}$ and the voltage of cell $n$ with the lowest voltage value among all cells of the segment (as described in claim 6), and the output is the reference equalization current of cell $n$ with the lowest voltage $I_{eq,ref}^{n}$ . This reference current $I_{eq,ref}^{n}$ and the current of cell $n,$ serve as inputs to the second *PI* controller [28], from which the PWM pulses [29] of the bidirectional *dc-dc* power converter [7] are generated.

8. Cell equalization method, according to claim 1(iii), **characterized by** the fact that the dependent (slave) equalization control algorithm with adjustable current, which is activated when $ND_{flag}$ == 1 is satisfied according to claims 2 and 4, and is implemented using the technique of Genetic Algorithms (GA), determines the equalization current for each cell of the segment (let's say of segment $j$) by minimizing the cost function

$$CF^{j} = w_1 \cdot \frac{E_{RAE,max}^{j}}{E_{RAE,total}^{j}} + w_2 \cdot \frac{E_{loss,total}^{j}}{E_{loss,max}^{j}} + w_3 \cdot \frac{\Delta t_{eq,total}^{j}}{\Delta t_{eq,max}^{j}}$$ , where

$E_{RAE,max}^{j}$ , $E_{loss,max}^{j}$ , $\Delta t_{eq,max}^{j}$ , $E_{RAE,total}^{j}$ , $E_{loss,total}^{j}$ and $\Delta t_{eq,total}^{j}$ represent the maximum residual available energy of the segment, the maximum energy losses in the segment's equalization circuit, the maximum equalization time of the segment, the total residual available energy of the segment, the total energy losses in the segment's equalization circuit, and the total equalization time of the segment, respectively, and $w_1$, $w_2$ and $w_3$ are the weighting factors for the residual available energy, energy losses, and equalization time, respectively, where $w_1 + w_2 + w_3 = 1$ holds true. The three weighting factors $w_1$, $w_2$ and $w_3$, are determined by the system administrator according to the priority assigned to the aforementioned objectives.

9. Cell equalization method, according to claims 1(iii), 2, and 8, **characterized by** the fact that the $E_{RAE,total}^{j}$ is the sum of all residual available energies of the $N$ cells in the $j$ segment (i.e., $E_{RAE,total}^{j} = \sum_{i=1}^{N} E_{RAE}^{i}$ ), and $E_{RAE,max}^{j}$ is the respective maximum value, the $E_{loss,total}^{j}$ is the sum of equalization losses of the /I/cells in the $j$ segment during the boost operation $E^j_{loss,boost}$ and the buck operation $E^j_{loss,buck}$ of the bidirectional *dc-dc* power converter [7] (i.e.,

$$E^j_{loss,total} = \sum_{i=1}^{N} E^i_{loss,boost} + \sum_{i=1}^{N} E^i_{loss,buck}$$

), and $E^j_{loss,max}$ is the respective maximum value, the $\Delta t^j_{eq,total}$ is the

$$\Delta t^j_{eq,total} = \sum_{i=1}^{N} \Delta t^i_{eq}$$

sum of equalization times of the *N* cells in the *j* segment (i.e., ), and the $\Delta t^j_{eq,max}$ is the respective maximum value.

**10.** Cell equalization method, according to claims 1(iv), 2, and 5, **characterized by** the fact that the dependent (slave) control algorithm of cell parameter estimation, specifically the impedance and the state-of-health (*SoH*) of each cell, is implemented using the EIS technique, and it determines the array of internal resistance values of the *N* cells in the *j*-segment with respect to their state-of-charge (*SoC*) and temperature $T_c$, i.e.

$$R^j_{seg} = \begin{bmatrix} R^1_c(SoC^1,T^1_c) & R^2_c(SoC^2,T^2_c) & \cdots & R^N_c(SoC^N,T^N_c) \end{bmatrix}$$, as well as the array of SoH values of the *N* cells in the *j* segment, i.e. $$SoH^j_{seg} = \begin{bmatrix} SoH^1_c & SoH^2_c & \cdots & SoH^N_c \end{bmatrix}$$.

Battery Energy Storage System
(BESS)

FIGURE 1

Matrix Power Switch System

FIGURE 2

$V_c^i$  $P_{load}$

**11**

$P_{load} > P_{dis\_th}$
OR
$V_c^i \leq V_{c\_th}$

NO

**14**

$\Delta Q_{RAE}^i > \Delta Q_{RAE\_th}$

NO

**16**

YES

YES

$P_{load} \leq P_{rit\_th}$

NO

**17**

YES

**12**

$D_{flag} == 1$

**13**

$D_{flag} == 0$

**15**

$ND_{flag} == 1$

$ND_{flag} == 0$

FIGURE 3

"Start" signal

$D_{flag} == 1$

NO

$ND_{flag} == 1$

NO

YES

YES

**20**

**18**

**24**

$SoH_{max}^i - SoH_{min}^i > SoH_{eq\_th}$

YES

Evaluate Cost
Function- $CF^j$

For $j$ segment
estimate the
impedance of each
cell through proposed
EIS technique

NAI

**25**

Find the two cells
with the lowest voltages
($k$ and $n$)
where $V_c^k > V_c^n$

Update equalization
current for each cell

**21**

$CF^j$ minimized

NO

**22**

YES

For $j$ segment
estimate the
SOH of each cell
through the proposed
EIS technique

**19**

**26**

$V_{ref}^i = V_c^k$

**23**

Set the optimal equa-
-lization current array of
the $j$-th segment

Start PI Controlled-based
Energy Support
Process

Start Equalization
Process

Define
$R_{seg}^j(SoC^i, T^i)$
and SoH$^i$ arrays

FIGURE 4

FIGURE 5

## EUROPEAN SEARCH REPORT

Europäisches Patentamt
European Patent Office
Office européen des brevets

**Application Number**

EP 24 16 9562

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2021/159710 A1 (FURUKAWA KIMIHIKO [JP] ET AL) 27 May 2021 (2021-05-27) * figures 2,3 * | 1-10 | INV. H02J7/00 |
| A | US 2014/117938 A1 (OUZAAROU HICHAME [FR] ET AL) 1 May 2014 (2014-05-01) * paragraphs [0038], [0042]; figures 1,4,7,8 * | 1-10 | |
| A | US 2021/333328 A1 (CHUNG STEVEN [US] ET AL) 28 October 2021 (2021-10-28) * figures 1,2,3,4,6 * | 1-10 | |

**TECHNICAL FIELDS SEARCHED (IPC)**

H02J

The present search report has been drawn up for all claims

| Place of search | Date of completion of the search | Examiner |
|---|---|---|
| Munich | 5 September 2024 | Ramcke, Ties |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 9562

This annex lists the patent family members relating to the patent documents cited in the above-mentioned European search report.
The members are as contained in the European Patent Office EDP file on
The European Patent Office is in no way liable for these particulars which are merely given for the purpose of information.

05-09-2024

| Patent document cited in search report | | Publication date | Patent family member(s) | | Publication date |
|---|---|---|---|---|---|
| US 2021159710 | A1 | 27-05-2021 | CN | 112055926 A | 08-12-2020 |
| | | | EP | 3787147 A1 | 03-03-2021 |
| | | | JP | 7325406 B2 | 14-08-2023 |
| | | | JP WO2019208163 A1 | | 20-05-2021 |
| | | | US | 2021159710 A1 | 27-05-2021 |
| | | | WO | 2019208163 A1 | 31-10-2019 |
| US 2014117938 | A1 | 01-05-2014 | CN | 103779888 A | 07-05-2014 |
| | | | EP | 2725683 A1 | 30-04-2014 |
| | | | FR | 2997577 A1 | 02-05-2014 |
| | | | JP | 2014086423 A | 12-05-2014 |
| | | | US | 2014117938 A1 | 01-05-2014 |
| US 2021333328 | A1 | 28-10-2021 | CN | 113812028 A | 17-12-2021 |
| | | | EP | 3906593 A1 | 10-11-2021 |
| | | | JP | 2022516914 A | 03-03-2022 |
| | | | KR | 20210150354 A | 10-12-2021 |
| | | | TW | 202042436 A | 16-11-2020 |
| | | | US | 2021333328 A1 | 28-10-2021 |
| | | | US | 2024103088 A1 | 28-03-2024 |
| | | | WO | 2020142398 A1 | 09-07-2020 |

EPO FORM P0459

For more details about this annex : see Official Journal of the European Patent Office, No. 12/82

**REFERENCES CITED IN THE DESCRIPTION**

**Patent documents cited in the description**

- US 2020287395 A1
- US 2019195956 A1
- KR 102111412 B1
- CN 110808627 A
- CN 110797959 A
- EP 3333008 A1
- US 2022224129 A1
- CN 109428361 A
- CN 206422545 U
- CN 105656142 A
- CN 105322560 A
- GR 1010317

- US 2020244074 A1
- EP 4102239 A1
- WO 2021256638 A1
- US 2016187427 A1
- KR 102201988 B1
- WO 2006057468 A1
- CN 103795123 A
- CN 103532193 A
- CN 103023107 A
- US 2017214252 A1
- KR 101827961 B1
- CN 112486020

**Non-patent literature cited in the description**

- **Y. ZHENG ; M. OUYANG ; L. LU ; J. LI ; X. HAN ; L. XU.** Online equalization for Lithium-Ion battery packs based on charging cell voltages: Part 2. fuzzy logic equalization. *J. Power Sources,* February 2014, vol. 247, 460-466
- **T. STUART ; W. ZHU.** Fast equalization for large lithium-ion batteries. *IEEE Trans. Aerosp. Electron. System,* 27 July 2009, vol. 24 (7
- **Y. SHANG ; B. XIA ; FEI LU ; C. ZHANG ; N. CUI ; C. MI.** A Switched-Coupling-Capacitor Equalizer for Series-Connected Battery Strings. *IEEE Trans. Power Electron.,* December 2016, vol. 32 (10), 7694-7706
- **M. KAUER ; S. NARAYANASWAMY ; S. STEINHORST ; S. CHAKRABORTY.** Rapid Analysis of Active Cell Balancing Circuits. *IEEE Trans. Computer-Aided Design of Integrated Circuits and Systems,* April 2017, vol. 36 (4), 694-698
- **K.-M. LEE ; S.-W. LEE ; Y.-G. CHOI ; B. KANG.** Active Balancing of Li-Ion Battery Cells Using Transformer as Energy Carrier. *IEEE Trans. Ind. Electron.,* February 2017, vol. 64 (2), 1251-1257
- **Y. YUANMAO ; K. W. E. CHENG ; Y. P. B. YEUNG'S.** Zero-current switching switched-capacitor zero-voltage-gap automatic equalization system for series battery string. *IEEE Trans. Power Electron.,* July 2012, vol. 27 (7), 3234-3242
- **T. HARTLEY ; I. HUSAIN.** A Battery Management System Using an Active Charge Equalization Technique Based on a DC/DC Converter Topology. *IEEE Trans. Ind. Appl.,* December 2013, vol. 49 (6), 2720-2729

- **N. JABBOUR ; E. TSIOUMAS ; N. KARAKASIS ; C. MADEMLIS.** Improved Monitoring and Battery Equalizer Control Scheme for Electric Vehicle Applications. *IEEE International Conference SDEMPED'2017*
- **N. JABBOUR ; E. TSIOUMAS ; M. KOSEOGLOU ; C. MADEMLIS.** Highly Reliable Monitoring and Equalization in a Hybrid Energy Storage System with Batteries and Supercapacitors for Electric Motor. *IEEE International Conference SPEC'2018*
- **Z. WEI ; F. PENG ; H. WANG.** An LCC-Based String-to-Cell Battery Equalizer With Simplified Constant Current Control. *IEEE Trans Power Electron,* 2022, vol. 37 (2), 1816-1827
- **Z. WEI ; H. WANG ; Y. LU ; D. SHU ; G. NING ; M. FU.** Bidirectional Constant Current String-to-Cell Battery Equalizer Based on L2C3 Resonant Topology. *IEEE Trans Power Electron,* 2023, vol. 38 (1), 666-677
- **S. JINLEI ; L. WEI ; T. CHUANYU ; W. TIANRU ; J. TAO ; T. YONG.** A Novel Active Equalization Method for Series-Connected Battery Packs Based on Clustering Analysis With Genetic Algorithm. *IEEE Trans Power Electron,* 2021, vol. 36 (7), 7853-7865
- **H. ZHANG ; Y. WANG ; H. QI ; J. ZHANG.** Active Battery Equalization Method Based on Redundant Battery for Electric Vehicles. *IEEE Trans Vehicular Technology,* 2019, vol. 68 (8), 7531-7543
- **M. EINHORN et al.** A Current Equalization Method for Serially Connected Battery Cells Using a Single Power Converter for Each Cell. *IEEE Trans Veh. Technol,* 2011, vol. 60 (9), 4227-4237

- **W. DIAO ; N. XUE ; V. BHATTACHARJEE ; J. JIANG ; O. KARABASOGLU ; M. PECHT.** Active battery cell equalization based on residual available energy maximization. *Appl Energy,* 2018, vol. 210, 690-698
- **F. S. J. HOEKSTRA ; H. J. BERGVELD ; M. C. F. DONKERS.** Optimal Control of Active Cell Balancing: Extending the Range and Useful Lifetime of a Battery Pack. *IEEE Transactions on Control Systems Technology,* 2022, vol. 30 (6), 2759-2766
- **Y.-X. WANG ; H. ZHONG ; J. LI ; W. ZHANG.** Adaptive estimation-based hierarchical model predictive control methodology for battery active equalization topologies: Part I-Balancing strategy. *J Energy Storage,* 2022, vol. 45, 103235